Europäisches Patentamt

(19) European Patent Office

Office européen des brevets

(11) Publication number : **0 568 390 A1**

(12) **EUROPEAN PATENT APPLICATION**

(21) Application number : **93303423.3**

(22) Date of filing : **30.04.93**

(51) Int. Cl.$^5$ : **G01R 31/36, G01D 18/00**

(30) Priority : **01.05.92 GB 9209505**

(43) Date of publication of application :
**03.11.93 Bulletin 93/44**

(84) Designated Contracting States :
**DE ES FR GB IT**

(71) Applicant : **LUCAS INDUSTRIES PUBLIC LIMITED COMPANY**
**Brueton House, New Road**
**Solihull, West Midlands B91 3TX (GB)**

(72) Inventor : **Rennison, John Henry**
**32 Watwood Road**
**Hall Green, Birmingham B28 0TN (GB)**

(74) Representative : **Gibson, Stewart Harry**
**URQUHART-DYKES & LORD Business**
**Technology Centre Senghennydd Road**
**Cardiff CF2 4AY (GB)**

(54) **Battery charge monitoring.**

(57)   A battery data transfer system for transferring data, representing characteristics of a battery, to a batter charge-monitoring system, comprises a data circuit (10) which includes passive electrical or electronic components (R1 to R4) the values of which represent the characteristics of the battery. The data circuit (10) is connectable to a sensing circuit (20) coupled to or forming part of the monitoring system, and provides output signals (31 to 34) dependent upon the values of the passive components (R1 to R4).

Figure 1

EP 0 568 390 A1

This invention relates to the charge monitoring of batteries, particularly lead-acid type batteries and particularly in vehicles.

Instrumentation and control systems in modern road vehicles are becoming increasingly complex, and a large variety of different sensors and transducers measure many aspects of the vehicle's operation. Various proposals have been made for providing an indication of the serviceability and state-of-charge of the vehicle's battery so that the driver can know when he has to replace or recharge the battery.

One proposed battery charge monitor for a vehicle includes a microprocessor which estimates the state-of-charge of the battery by measuring the equilibrium (settled, off-load) voltage of the battery when rested and integrating over time the currents flowing into or out of the battery. This monitor assumes that lead-acid batteries of the same design have the same maximum charge capacity when new. The monitor then defines the amount of charge stored in a battery as a percentage of the charge that a fully charged new battery of the same design would deliver in a standardized 20 hour discharge at 25°C . The battery equilibrium voltage indicates this to the monitor on a linear scale which is a characteristic of the battery design. However, any given model of vehicle may be fitted with one of a variety of different designs of battery either when new, e.g. to suit different environments, or when in service.

EP-A-0280916 proposes a battery monitor comprising a microprocessor connected to a data circuit housed inside the battery casing. The data circuit comprises an $E^2PROM$ in which the characteristics of that particular battery are stored. In use, the measured voltage across the battery terminals is compared with the stored data so as to determine the instantaneous state-of-charge of the battery. The data circuit is expensive to manufacture, and the cost of the circuit increases the cost of the battery.

We have now devised a battery data transfer system which uses a data circuit of simple and inexpensive form.

In accordance with this invention there is provided a battery data transfer system which comprises a sensing circuit and a data circuit connectable to the sensing circuit, the data circuit including one or more passive electrical or electronic components the value(s) of which represent one or more characteristics of a battery, and the sensing circuit being arranged to provide one or more signals dependent upon said component value(s).

Also in accordance with this invention, there is provided a battery data circuit which includes one or more passive electrical or electronic components the value(s) of which represent one or more characteristics of a battery, the data circuit being connectable to a sensing circuit arranged to provide one or more signals dependent upon said component value(s).

Further in accordance with this invention, there is provided a battery data sensing circuit to which a battery data circuit is connectable, the sensing circuit being arranged to provide one or more signals dependent upon the value(s) of one or more passive electrical or electronic components of the data circuit.

It will be appreciated that the battery data circuit may be of simple and inexpensive form, preferably supplied with each battery. The battery data circuit is then connected to the sensing circuit, which is incorporated in the vehicle, so that the sensing circuit can "read" the battery characteristic(s) from the data circuit. The sensing circuit is coupled to or forms part of a battery monitoring system of the vehicle: this system is able to determine, from the acquired battery data, what level (quantity) of charge is held by the battery, for any measured open-circuit battery voltage. Thereafter, the monitor periodically measures the open-circuit battery voltage and provides an output indicating the state-of-charge.

Preferably the data carried by the battery data circuit comprises the battery capacity when new and a plurality of points on a battery equilibrium voltage versus state-of-charge curve. For most batteries this curve is substantially a straight line, so that in an alternative embodiment the data circuit may carry data representing one point on the curve and the slope of the curve.

The data-representing components of the battery data circuit are preferably resistors, but other passive components such as capacitors or inductors may be used.

Preferably the resistors of the battery data circuit are connected in parallel between an input and a plurality of outputs of the data circuit, the input being arranged for connection to a stabilised voltage and the outputs being arranged for connection to the sensing circuit.

Preferably each resistor of the battery data circuit is connected to a resistor of known value in the sensing circuit so as to form a potential divider, when the battery data circuit is connected to the sensing circuit, and the sensing circuit includes a processing element connected to points in the potential dividers so as to measure the voltages at these points.

The arrangement is preferably such that the measured voltage is proportional to the battery characteristic being represented, but one or more of the measured voltages may be exponentially or otherwise related to the respective battery characteristic so that a wider range of battery characteristics can be interpreted.

Preferably the processing element comprises an analog-to-digital converter and a microprocessor.

The battery data circuit preferably comprises a removable tag which is supplied with the battery. The tag may be connected to the sensing circuit at a location remote from the battery.

An embodiment of this invention will now be described by way of example only and with reference to the accompanying drawings, in which:

FIGURE 1 is a circuit diagram of a battery data transfer system in accordance with this invention;

FIGURE 2 shows a graph giving the variation of measured voltage with data circuit resistance, for the system shown in Figure 1; and

FIGURE 3 shows a graph giving the variation of measured voltage with the battery capacity represented by one resistor of the data circuit.

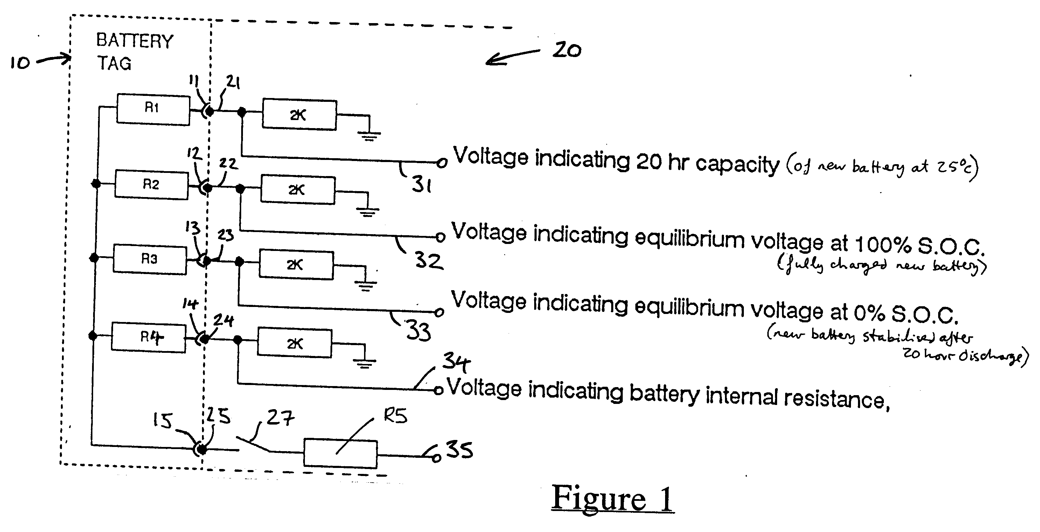

Referring to Figure 1 of the drawings, there is shown a battery data transfer system comprising a battery data tag 10 when connected to a sensing circuit 20. The battery tag 10 is supplied with a battery and holds data representing characteristics of that battery: this data is held by four resistors R1, R2, R3, R4 connected in parallel between an input terminal 15 and respective output terminals 11,12,13,14 of the battery tag.

The sensing circuit 20 is coupled to or forms part of a battery monitoring system of the vehicle, and comprises four 2K resistors connected in parallel between input terminals 21,22,23,24 and ground. The terminals 11,12,13,14,15 on the battery tag 10 connect with terminals 21,22,23,24 and another terminal 25 on the sensing circuit 20. Voltage sensing wires 31,32,33,34 are connected to the terminals 21,22,23,24 on the sensing circuit.

A positive supply voltage wire 35 is connected via a resistor R5 and a switch 27 to the terminal 25 on the sensing circuit 20, and hence to the input terminal 15 of the battery tag 10.

In use, a stabilised supply voltage $V_{cc}$ is applied to wire 35, of a value chosen to be below the equilibrium voltage of a discharged battery, e.g. 5 Volts. The voltage VN on the respective sensing wires 31,32,33,34 can be shown to be:

$$Equation\ 1 \qquad VN = V_{cc} \times \frac{2K}{2K + RN}$$

where RN is the value of the respective resistor R1,R2,R3 or R4 plus the short circuit protection resistor R5 (and assuming a value of 2K for each of the series resistors of the sensing circuit 20).

Each sensing wire 31,32,33,34 is connected to an 8 bit analog-to-digital converter which converts the measured voltage to a binary number. In this a measured zero volts gives an output of 0 and a measured 5 volts gives a binary number output of 255.

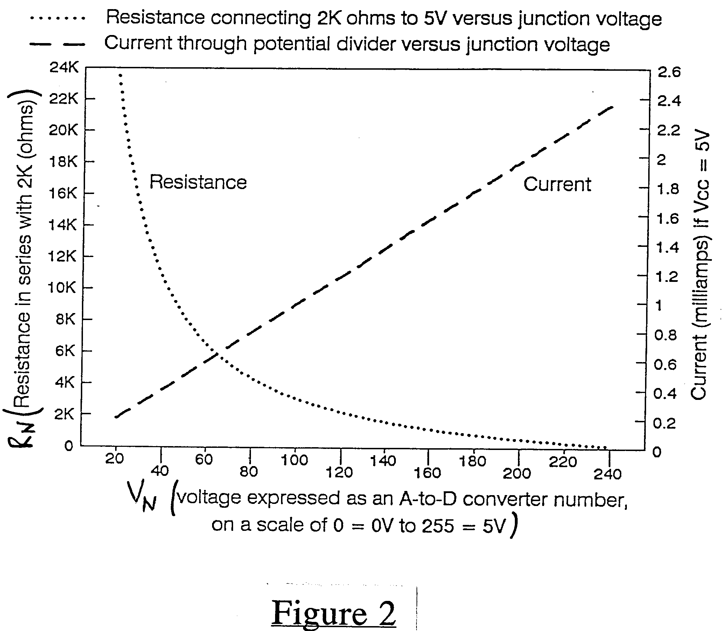

Referring to Figure 2, there is shown a graph of resistance RN versus voltage expressed as an analog-to-digital converter number. From the graph it can be seen how the measured voltage VN alters with variation of the resistance value RN. Thus different parameters of the battery can be represented by selecting different values for the resistors R1,R2,R3,R4. In the embodiment of Figure 1 for example, the equilibrium voltage at 100% state-of-charge is represented by the value of R2. Similarly R3 represents the equilibrium voltage at 0% state-of-charge, R4 represents the internal resistance of the battery, and R1 represents the 20 hour capacity of the battery when new and at 25°C.

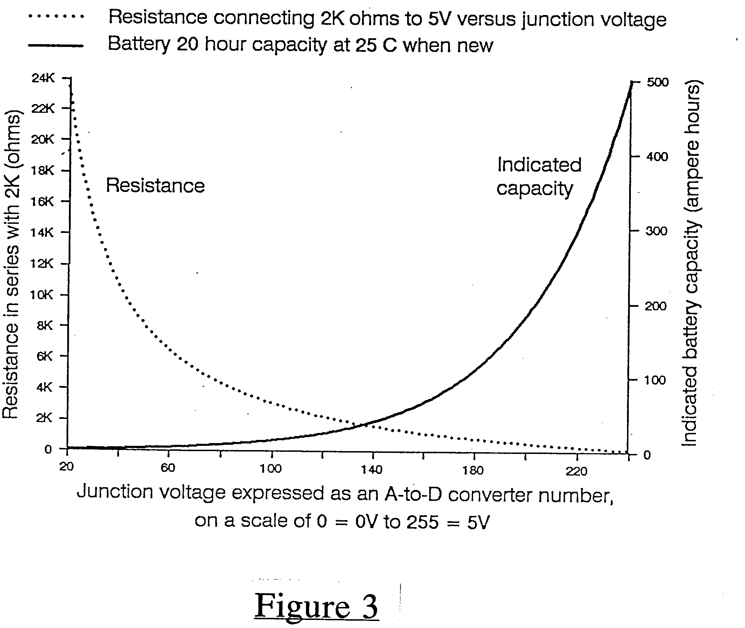

The range of capacities of available batteries is very wide, typically from 2 to 500 Ampere hours, with most car batteries having a capacity between 25 and 90 Ampere hours. In the embodiment of Figure 1, preferably exponential scaling is used to represent the battery capacity, so that each successive digit of the analogue-to-digital number represents a constant percentage change in the capacity. Figure 3 gives a graph of battery capacity versus measured voltage, using this exponential scaling. The following equation is used to convert from measured voltage to the battery capacity:

$$Equation\ 2 \qquad Ah = P(1 + r)^n$$

where

Ah = battery capacity

P = minimum capacity (2Ah)

r = proportional increase in battery capacity per A-to-D digit (=% increase divided by 100)

n = number of A-to-D digits above a minimum scale value.

In this embodiment, a 2 Ampere hour battery is represented by an analogue number of 20 (the minimum scale value) and each increment in the analogue-to-digital number represents a 2.5415 % growth in the battery capacity. Thus the maximum scale value 240 represents a battery capacity of 500 Ampere hour.

From Equation 1, a resistance RN of value 2K250 would produce a voltage of:

$$VN = 5 \times \frac{2K}{2K + 2K250}$$

$$VN = 2.353\ Volts$$

expressed as an analog-to-digital number:

$$VN = \frac{255}{5} \times 2.353\ Volts$$

$$VN = 120$$

From Equation 2, the analog-to-digital number 120 indicates a battery capacity Ah of:

$$Ah = 2 \times (1 + 0.025415)^{(120 - 20)}$$

$$Ah = 2 \times 1.025415^{100}$$

$$Ah = 2 \times 12.3$$

$$Ah = 24.6Ah$$

Therefore a resistance RN of value 2K250 represents a 24.6 Ampere hour battery.

The resistors R1,R2,R3,R4 may be etched or printed on a low cost substrate forming the tag 10. The tag can be plugged directly into the sensing circuit at a point remote from the battery. It will be appreciated that a low cost tag can be supplied with or made available for every battery, so that the state-of-charge of the battery can be monitored if the vehicle is fitted with an appropriate battery monitor which includes or has the sensing circuit coupled to it.

## Claims

**1)** A battery data transfer system, comprising a sensing circuit (20) and a data circuit (10) connectable to the sensing circuit (20), the data circuit (10) including one or more passive electrical or electronic components (R1 to R4) the value(s) of which represent one or more characteristics of a battery, and the sensing circuit (20) being arranged to provide one or more signals (31 to 34) dependent upon said component value(s).

**2)** A battery data transfer system as claimed in claim 1, in which the data-representing components (R1 to R4) comprise resistors connected in parallel between an input (15) and a plurality of outputs (11 to 14) of the data circuit (10), the input (15) being arranged to receive a stabilised voltage and the outputs (11 to 14) being connectable to the sensing circuit.

**3)** A battery data transfer system as claimed in claim 2, in which each resistor (R1 to R4) of the data circuit (10) is connected to a resistor in the sensing circuit to form a potential divider, a junction point of which provides a said signal.

**4)** A battery data transfer system as claimed in any preceding claim, in which said passive components (R1 to R4) represent the capacity of the battery when new and a plurality of points on an equilibrium voltage versus state-of-charge curve for the battery.

**5)** A battery data transfer system as claimed in any one of claims 1 to 3, in which said passive components (R1 to R4) represent the capacity of the battery when new and one point on, and the slope of, an equilibrium voltage versus state-of-charge curve for the battery.

**6)** A battery data circuit, comprising one or more passive electrical or electronic components (R1 to R4) the values of which represent one or more characteristics of a battery, the data circuit being connectable to a sensing circuit (20) arranged to provide one or more signals (31 to 34) dependent upon said component value(s).

**7)** A battery data circuit as claimed in claim 6, in which the data-representing components (R1 to R4) comprise resistors connected in parallel between an input (15) and a plurality of outputs (11 to 14) of the data circuit, the input (15) being arranged to receive a stabilised voltage and the outputs (11 to 14) being connectable to the sensing circuit.

**8)** A battery data sensing circuit to which a battery data circuit is connectable, the sensing circuit having one or more inputs (21 to 24) connectable to passive electrical or electronic components of the battery data circuit, and means to provide one or more output signals (31 to 34) dependent upon the value(s) of said passive component(s).

**9)** A battery data sensing circuit as claimed in claim 8, in which said output signal providing means comprises one or more resistors each connectable to a passive component of the battery data circuit to form a potential divider, a junction point of which provides a said output signal.

BATTERY TAG

10 →

← 20

R1 — 11 21 — 2K — ⏚
R2 — 12 22 — 2K — ⏚
R3 — 13 23 — 2K — ⏚
R4 — 14 24 — 2K — ⏚

31 — o Voltage indicating 20 hr capacity (of new battery at 25°c)

32 — o Voltage indicating equilibrium voltage at 100% S.O.C. (fully charged new battery)

33 — o Voltage indicating equilibrium voltage at 0% S.O.C. (new battery stabilises after 20 hour discharge)

34 — o Voltage indicating battery internal resistance,

15 25 27 R5
— o 35

EP 0 568 390 A1

Figure 1

Figure 2

······ Resistance connecting 2K ohms to 5V versus junction voltage
——— Battery 20 hour capacity at 25 C when new

Junction voltage expressed as an A-to-D converter number,
on a scale of 0 = 0V to 255 = 5V

## Figure 3

**European Patent Office**

**EUROPEAN SEARCH REPORT**

Application Number

EP 93 30 3423

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2 239 567 (TECHNOPHONE) * the whole document * | 1-3,6-9 | G01R31/36 G01D18/00 |
| Y | | 4,5 | |
| D,Y | EP-A-0 280 916 (ELEKTRON-BREMEN) * abstract; figures * | 4,5 | |
| A | ELECTRONICS WORLD AND WIRELESS WORLD vol. 96, no. 1654, August 1990, SURREY GB page 686 PALMER 'Self-id for plugs and sensors' | 1,6 | |

TECHNICAL FIELDS SEARCHED (Int. Cl.5 )

G01R
G01D

The present search report has been drawn up for all claims

| Place of search | Date of completion of the search | Examiner |
|---|---|---|
| THE HAGUE | 10 AUGUST 1993 | LLOYD P.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)